# DEMANDE DE BREVET EUROPEEN

(11) **EP 4 340 562 A1**
(43) Date de publication de la demande: **20.03.2024**
(21) Numéro de dépôt: 23198165.5
(22) Date de dépôt: 19.09.2023
(51) Int. Cl.: H05K 7/20

(54) **DISPOSITIF D'ÉCHANGE THERMIQUE, ENSEMBLE COMPRENANT UN TEL DISPOSITIF D'ÉCHANGE THERMIQUE ET PROCÉDÉ DE FABRICATION ASSOCIÉS**

(30) Priorité: 19.09.2022 FR 2209428
(71) Demandeur: ALSTOM Holdings, 93400 Saint-Ouen-sur-Seine (FR)
(72) Inventeur: AUDEMAR, Christophe, 65310 Horgues (FR); COLLET, Andrea, 64320 Lee (FR); DAGUIN, Yann, 65310 Horgues (FR)
(74) Mandataire: Lavoix

(57) **Abrégé**

L'invention concerne un dispositif (22) d'échange thermique définissant un canal de circulation (26) d'un fluide (28) apte à être réchauffé ou refroidi par échange thermique avec une unité (24) destinée à être refroidie ou réchauffée, le canal comprenant une portion de canal (51, 52, 53) comprenant des première et deuxième voies (V1, V2) de circulation du fluide selon une direction principale de circulation (DP) respectivement dans un premier sens (S1) et dans un deuxième sens (S2), séparées par une paroi de séparation (P1, P2, P3).

Le dispositif comprend des premier et deuxième modules (M1, M2) d'échange thermique obtenus par fabrication additive, présentant des régions de passage de fluide. Les premier et deuxième modules s'étendent exclusivement dans la première voie, respectivement dans la deuxième voie.

Lesdits modules étant agencés en regard l'un de l'autre selon une direction perpendiculaire à la direction principale de circulation et séparés par la paroi de séparation.

## Description

La présente invention concerne un dispositif d'échange thermique. La présente invention concerne également un ensemble comprenant un tel dispositif d'échange thermique et une unité apte à être réchauffée ou refroidie. La présente invention concerne également un procédé de fabrication d'un dispositif d'échange thermique.

De manière connue, les modules de puissance, notamment de véhicules ferroviaires, comprennent des composants électriques, tels que des composants semiconducteurs de type transistors bipolaires à grille isolée (aussi connus sous le nom de composants IGBT, de l'anglais « Insulated Gate Bipolar Transistor »), qui sont susceptibles de dégager une chaleur importante en cours de leur fonctionnement. Or, les performances de ces composants électriques diminuent de manière conséquente lorsqu'ils sont soumis à des températures élevées. Par ailleurs, la durée de vie des composants électriques est négativement impactée, et des opérations de maintenance fréquentes sont nécessaires.

Ainsi, afin d'améliorer le refroidissement des composants électriques des modules de puissance, il est connu d'équiper les modules de puissance de dispositifs de refroidissement.

Il est notamment connu de disposer les composants électroniques sur une plaque de refroidissement à l'intérieur de laquelle circule un fluide caloporteur. La plaque de refroidissement comprend un corps dans lequel sont usinés, par exemple par fraisage, des canaux parallèles les uns aux autres. Le fluide caloporteur circule dans ces canaux parallèles selon une direction de circulation pour éliminer par conduction et/ou convection une partie de la chaleur dissipée par les composants électroniques. En particulier, une telle plaque usinée présente une première portion de plaque présentant un premier ensemble de canaux usinés et une deuxième portion de plaque présentant un deuxième ensemble de canaux usinés. Dans une telle plaque connue, le fluide est configuré pour circuler dans le premier ensemble de canaux usinés selon la direction de circulation dans un premier sens et dans le deuxième ensemble de canaux usinés selon la direction de circulation dans un deuxième sens opposé au premier sens. Ainsi, une seule et même plaque usinée est utilisée pour la circulation du fluide dans deux sens de circulation différent.

Cependant, une telle plaque de refroidissement ne donne pas entièrement satisfaction. En particulier, elle ne permet d'évacuer qu'une part limitée de la chaleur générée par les composants électriques lors de leur fonctionnement. En outre, la réalisation d'une telle plaque de refroidissement est fastidieuse et en particulier l'usinage des canaux.

Un but de la présente invention est de pallier les inconvénients précités en proposant un dispositif d'échange thermique définissant un canal de circulation d'un fluide apte à être refroidi ou réchauffé par échange thermique avec une unité destinée à être refroidie ou réchauffée permettant d'assurer un échange thermique performant, tout en étant facile à fabriquer.

A cet effet, l'invention concerne un dispositif d'échange thermique définissant un canal de circulation d'un fluide apte à être réchauffé ou refroidi par échange thermique avec une unité destinée à être refroidie ou réchauffée, le canal de circulation comprenant une entrée, une sortie et au moins une portion de canal s'étendant entre l'entrée et la sortie, la portion de canal comprenant au moins une première voie de circulation destinée à conduire le fluide selon une direction principale de circulation dans un premier sens et au moins une deuxième voie de circulation distincte de la première voie, destinée à conduire le fluide selon la direction principale de circulation dans un deuxième sens opposé au premier sens, la première voie et la deuxième voie étant séparées l'une de l'autre par une paroi de séparation,
le dispositif d'échange thermique comprenant, en outre, au moins un premier module d'échange thermique et un deuxième module d'échange thermique, le premier module d'échange thermique s'étendant exclusivement dans la première voie de circulation et le deuxième module d'échange thermique s'étendant exclusivement dans la deuxième voie de circulation, les premier et deuxième modules d'échange thermique présentant des régions de passage de fluide et étant obtenus par fabrication additive,
le premier module d'échange thermique et le deuxième module d'échange thermique étant agencés en regard l'un de l'autre selon une direction sensiblement perpendiculaire à la direction principale de circulation et étant séparés l'un de l'autre par la paroi de séparation.

On comprend que le dispositif d'échange thermique selon l'invention est modulaire. En effet, il est possible de personnaliser le dispositif d'échange thermique selon l'invention en choisissant des modules d'échange thermique présentant des régions de passages de fluide optimales et des surfaces d'échange thermique optimales en fonction des capacités de refroidissement/réchauffement nécessaires pour refroidir/réchauffer les unités.

Du fait que les modules d'échange thermiques sont réalisés par fabrication additive, cela permet de réaliser des formes ou des assemblages qui ne peuvent être obtenues par les autres techniques de fabrication tels que le soudage, l'usinage, le moulage ou le forgeage. Ainsi, grâce à la fabrication additive, il est possible d'obtenir des modules d'échange thermique présentant des géométries internes plus complexes, ce qui permet d'adapter la géométrie de ces modules pour améliorer la capacité d'échange thermique du dispositif d'échange thermique par rapport aux dispositifs d'échange thermique de l'état de la technique.

En outre, du fait que le dispositif d'échange thermique comprend un premier et un deuxième modules séparés par une paroi de séparation et agencés côte à côte selon une direction sensiblement perpendiculaire à la direction principale de circulation, cela permet de positionner une unité destinée à être refroidie ou réchauffée sur une face externe du dispositif d'échange thermique au droit du premier et deuxième module dans lesquels le fluide présente des sens de circulation opposé. Cela permet d'homogénéiser les échauffements du fluide au droit des unités destinées à être refroidie ou réchauffées. En effet, cela permet d'augmenter la vitesse débitante par réduction de largeur du canal pour un meilleur échange thermique.

De plus, le dispositif d'échange thermique est plus facile à réaliser par rapport aux dispositifs de l'état de la technique comprenant la plaque usinée. En effet, dans le dispositif selon l'invention, au lieu de l'unique plaque usinée, deux modules sont fabriqués et placés là où il est nécessaire tout en ayant une structure adaptée aux besoins d'échange thermique.

Selon d'autres aspects de l'invention, le dispositif d'échange thermique comprend une ou plusieurs des caractéristiques suivantes, prises isolément ou selon toute combinaison technique possible :
- le dispositif d'échange thermique comprend, en outre, un troisième module d'échange thermique et un quatrième module d'échange thermique, le troisième module d'échange thermique s'étendant exclusivement dans la première voie et étant espacé du premier module d'échange thermique selon la direction principale de circulation, le quatrième module d'échange thermique s'étendant exclusivement dans la deuxième voie et étant espacé du deuxième module d'échange thermique selon la direction principale de circulation, le troisième module d'échange thermique et le quatrième module d'échange présentant des régions de passage de fluide et étant obtenus par fabrication additive, le troisième module d'échange thermique et le quatrième module d'échange thermique étant agencés en regard l'un de l'autre selon une direction sensiblement perpendiculaire à la direction principale de circulation et étant séparés l'un de l'autre par la paroi de séparation.
- le dispositif d'échange thermique comprend une structure de base et un capot fixé à la structure de base, de préférence par brasure, la structure de base et le capot présentant des surfaces internes délimitant entre elles au moins en partie un volume interne du dispositif d'échange thermique, le volume interne définissant le canal de circulation.
- les modules d'échange thermique sont fixés par brasure à la surface interne de la structure de base ou du capot.
- le canal de circulation présente la forme d'un serpentin, le canal de circulation comprenant au moins une première portion de canal et une deuxième portion de canal agencées entre l'entrée et la sortie, pour chacune des portions de canal parmi la première portion de canal et la deuxième portion de canal, la première voie de circulation et la deuxième voie de circulation de cette portion de canal étant séparées l'une de l'autre par une paroi de séparation associée à cette portion de canal,
   pour chacune des portions de canal parmi la première portion de canal et la deuxième portion de canal, le dispositif d'échange thermique comprend au moins un premier module d'échange thermique et un deuxième module d'échange thermique, le premier module d'échange thermique s'étendant exclusivement dans la première voie de circulation de cette portion de canal et le deuxième module d'échange thermique s'étendant exclusivement dans la deuxième voie de circulation de cette portion de canal, les premier et deuxième modules d'échange thermique présentant des régions de passage de fluide et étant obtenus par fabrication additive,
   pour chacune des portions de canal parmi la première portion de canal et la deuxième portion de canal, le premier module d'échange thermique et le deuxième module d'échange thermique de cette portion étant agencés en regard l'un de l'autre selon une direction sensiblement perpendiculaire à la direction principale de circulation et étant séparés l'un de l'autre par la paroi de séparation associée à cette portion de canal.
- le dispositif d'échange thermique comprend une cloison séparant la première portion de canal et la deuxième portion de canal.
- au moins deux modules d'échange thermique présentent des régions de passage de fluide différentes d'un module d'échange thermique à l'autre.

L'invention concerne également un ensemble comprenant au moins un dispositif d'échange thermique tel que décrit ci-dessus et au moins une unité apte à être refroidie ou réchauffée par le dispositif d'échange thermique, le dispositif d'échange thermique comprenant une structure de base et un capot fixé à la structure de base, de préférence par brasure, la structure de base et le capot présentant des surfaces internes délimitant entre elles un volume interne du dispositif d'échange thermique, le volume interne définissant le canal de circulation du dispositif d'échange thermique, ladite unité étant agencée en contact avec une zone d'une surface externe du capot ou de la structure de base, dite « surface de contact », la surface de contact s'étendant à l'extérieur du volume interne.

Selon d'autres aspects de l'invention, ladite unité s'étend sur la zone de contact à la fois au droit du premier module d'échange thermique et du deuxième module d'échange thermique.

L'invention concerne également un procédé de fabrication d'un dispositif d'échange thermique tel que décrit précédemment comprenant au moins les étapes de :
- réalisation d'un canal de circulation d'un fluide apte à être réchauffé ou refroidi par échange thermique avec une unité apte à être refroidie ou réchauffée, le canal de circulation comprenant une entrée, une sortie et au moins une portion de canal s'étendant entre l'entrée et la sortie, la portion de canal comprenant au moins une première voie de circulation destinée à conduire le fluide selon une direction principale de circulation dans un premier sens et au moins une deuxième voie de circulation distincte de la première voie, destinée à conduire le fluide selon la direction principale de circulation dans un deuxième sens opposé au premier sens, la première voie et la deuxième voie étant séparées l'une de l'autre par une paroi de séparation,
- réalisation d'au moins un premier module d'échange thermique et un deuxième module d'échange thermique par fabrication additive, les premier et deuxième modules d'échange thermique présentant chacun des régions de passage de fluide,
- agencement du premier module d'échange thermique dans la première voie de circulation de sorte qu'il s'étende exclusivement dans la première voie de circulation,
- agencement du deuxième module d'échange thermique dans la deuxième voie de sorte qu'il s'étende exclusivement dans la deuxième voie de circulation, qu'il soit agencé en regard du premier module d'échange thermique selon une direction sensiblement perpendiculaire à la direction principale de circulation et qu'il soit séparé du premier module d'échange thermique par la paroi de séparation.

D'autres aspects et avantages de l'invention apparaitront à la lecture de la description qui suit, donnée à titre d'exemple et faite en référence aux dessins annexés, parmi lesquels :
- la figure 1 est une vue schématique de dessus d'un ensemble selon l'invention, comprenant un dispositif d'échange thermique et des unités émettrices de chaleur,
- la figure 2 est une vue du dessus de l'intérieur du dispositif d'échange thermique de la figure 1,
- la figure 3 est une vue en coupe axial de l'ensemble de la figure 1 selon le plan de coupe III-III repéré sur la figure 1,
- la figure 4 est une vue en coupe transversale du dispositif d'échange thermique de la figure 1 selon le plan de coupe IV-IV repéré sur la figure 1,
- la figure 5 et la figure 6 sont des représentations schématiques respectivement en perspective et en coupe selon le plan de coupe VI-VI repéré sur la figure 5 d'un premier exemple de module d'échange thermique de l'ensemble de la figure 1,
- la figure 7 et la figure 8 sont des représentations schématiques respectivement en perspective et en coupe selon le plan de coupe VIII-VIII repéré sur la figure 7 d'un deuxième exemple de module d'échange thermique de l'ensemble de la figure 1,
- la figure 9 et la figure 10 sont des représentations schématiques respectivement en perspective et en coupe selon le plan de coupe X-X repéré sur la figure 9 d'un troisième exemple de module d'échange thermique de l'ensemble de la figure 1,
- la figure 11 et la figure 12 sont des représentations schématiques respectivement en perspective et en coupe selon le plan de coupe XII-XII repéré sur la figure 11 d'un quatrième exemple de module d'échange thermique de l'ensemble de la figure 1.

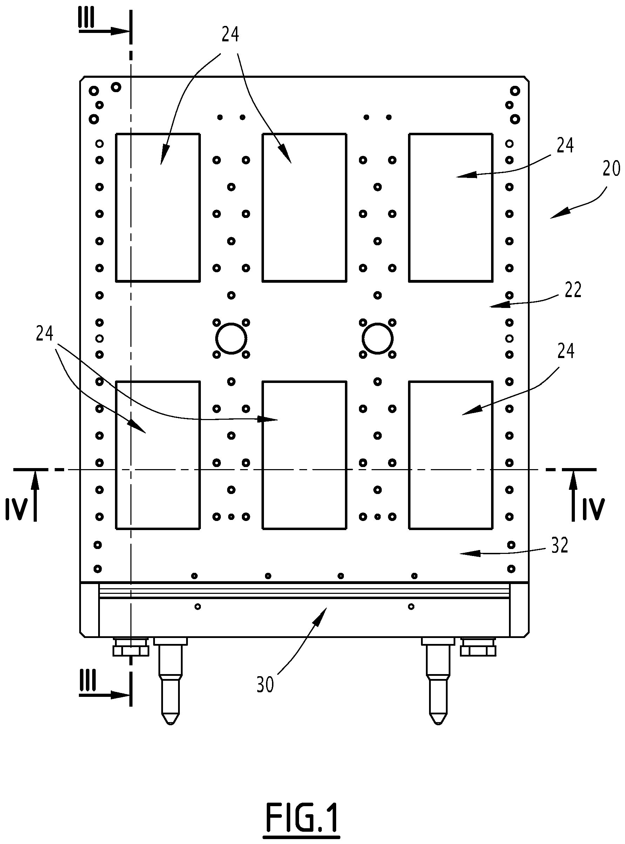

Un ensemble 20 d'échange thermique est décrit en référence aux figures 1 à 6.

L'ensemble 20 d'échange thermique est par exemple embarqué à bord d'un véhicule, notamment un véhicule ferroviaire. En d'autres termes, le véhicule ferroviaire comprend l'ensemble 20 d'échange thermique.

Comme visible sur la figure 1, l'ensemble 20 d'échange thermique comprend un dispositif 22 d'échange thermique et au moins une unité 24 destinée à être réchauffée ou refroidie par le dispositif 22 d'échange thermique.

Par exemple, l'unité 24 émet de la chaleur et est destinée à être refroidie.

Par exemple, l'unité 24 est un module de puissance d'un matériel roulant ferroviaire, connu en soi, comprenant des composants électriques, tels que des composants semiconducteurs de type transistors bipolaires à grille isolée (aussi connus sous le nom de composants IGBT, de l'anglais « Insulated Gate Bipolar Transistor »), qui sont susceptibles de dégager une chaleur importante en cours de leur fonctionnement.

Comme visible sur la figure 1, l'ensemble 20 comprend plusieurs unités 24, notamment six unités 24. De telles unités 24 sont représentées schématiquement par des rectangles sur la figure 1.

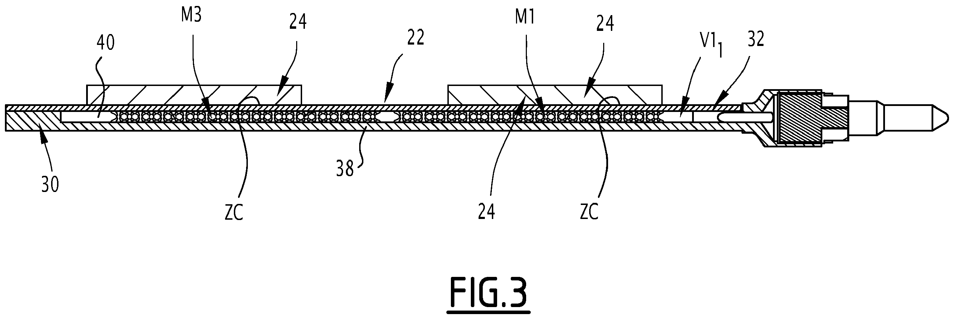

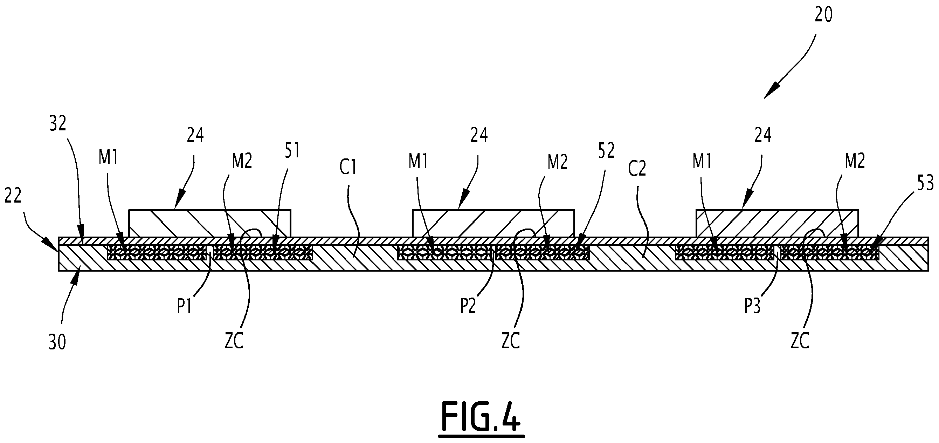

Les unités 24 sont en contact avec l'une des surfaces externes du dispositif 22 d'échange thermique, dite « surface de contact externe ». En particulier, comme visible sur la figure 1, chaque unité 24 est en contact avec une zone respective de la surface de contact externe, dite « zone de contact ZC » (voir les figures 3 et 4). Les zones de contacts ZC sont avantageusement disjointes.

Chaque unité 24 comprend par exemple une semelle en aluminium en contact avec la zone de contact ZC associée à cette unité 24.

Par exemple, une couche de graisse (non visible sur les figures) s'étend entre chaque unité 24 et la zone de contact ZC associé à cette unité 24.

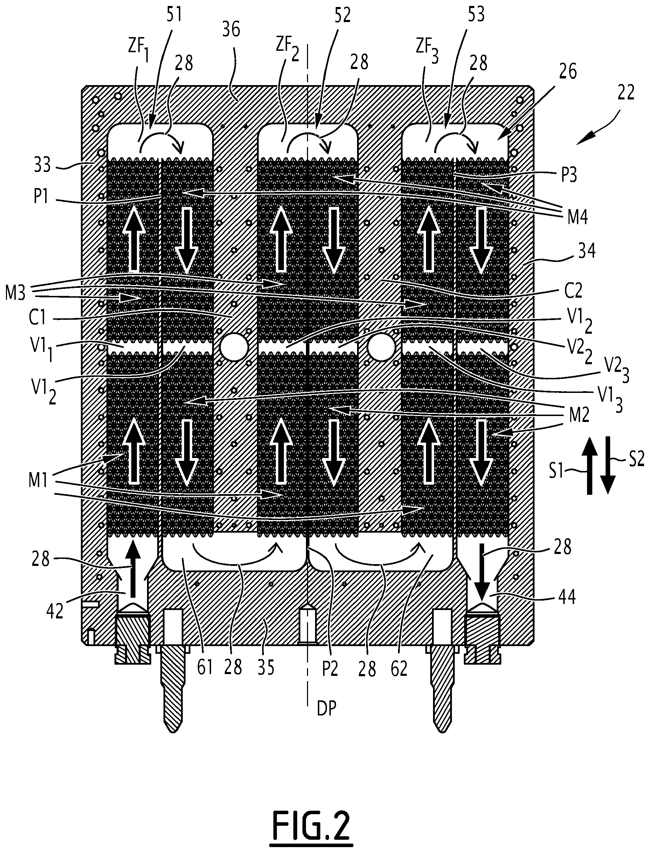

En référence aux figures 2 à 4, le dispositif 22 d'échange thermique selon l'invention définit un canal de circulation 26 d'un fluide 28 apte à être réchauffé ou refroidi par échange thermique avec l'unité 24 de sorte à refroidir ou réchauffer l'unité 24. Dans le cas d'espèce dans lequel l'unité 24 est une unité destinée à être refroidie, le fluide 28 est apte à être réchauffée par échange thermique avec ladite unité 24 de sorte à la refroidir.

En particulier, le dispositif 22 d'échange thermique comprend une structure de base 30, un capot 32 (visible sur les figures 3 et 4) et des modules d'échange thermique qui seront décrits plus en détail par la suite. Le dispositif 22 d'échange thermique comprend en outre, dans cet exemple, une première paroi de séparation P1, une deuxième paroi de séparation P2, une troisième paroi de séparation P3, une première cloison C1 et une deuxième cloison C2.

Par exemple, comme visible sur la figure 2, la structure de base 30 comprend plusieurs parois latérales 33, 34, 35, 36 et un fond 38 (visible sur les figures 3 et 4).

La structure de base 30 comprend par exemple quatre parois latérales 33, 34, 35, 36 s'étendant sensiblement perpendiculairement au fond 38, par exemple une première et une deuxième parois longitudinales 33, 34 ainsi qu'une première et une deuxième parois transversales 35, 36.

Comme visible sur les figures 3 et 4, le fond 38 est par exemple plan.

Comme visible sur les figures 3 et 4, le capot 32 se présente par exemple sous la forme d'une plaque.

Le capot 32 est par exemple fixé à la structure de base 30 par brasure, par exemple par brasure sous vide.

Comme visible en particulier sur la figure 3, la structure de base 30 et le capot 32 présentent des surfaces internes délimitant entre elles au moins en partie un volume interne 40 du dispositif 22 d'échange thermique.

Par exemple, comme visible sur la figure 2, la surface externe du capot 32 définie la surface de contact externe présentant les zones de contact ZC. En variante, la surface externe du fond 38 de la structure de base 30 définie la surface de contact externe présentant les zones de contact ZC.

Comme visible sur la figure 2, la première paroi P1 de séparation s'étend selon une direction d'élongation. La première paroi P1 de séparation fait saillie de la surface interne de la première paroi transversale 35 dans laquelle est ménagée l'entrée 42 et la sortie 44.

La deuxième paroi P2 de séparation s'étend selon la direction d'élongation. La deuxième paroi P2 de séparation fait saillie de la surface interne de la première paroi transversale 35.

La troisième paroi P3 de séparation s'étend selon la direction d'élongation. La troisième paroi P3 de séparation fait saillie de la surface interne de la première paroi transversale 35.

Les première, deuxième et troisième parois P1, P2, P3 de séparation sont solidaires de la surface interne de la première paroi transversale 35.

La première cloison C1 s'étend selon la direction d'extension. La première cloison C1 fait saillie de la surface interne de la deuxième paroi transversale 36.

La deuxième cloison C2 s'étend selon la direction d'extension. La deuxième cloison C2 fait saillie de la surface interne de la même deuxième paroi transversale 36.

Les première et deuxième cloisons C1, C2 sont solidaires de la surface interne de la deuxième paroi transversale 36.

Les surfaces internes de la structure de base 30 et du capot 32, la première paroi P1 de séparation, la deuxième paroi P2 de séparation, la première cloison C1 et la deuxième cloison C2 délimitent entre elles le volume interne 40 du dispositif 22 d'échange thermique.

Le volume interne 40 définit le canal de circulation 26 du dispositif 22 d'échange thermique.

Ainsi, les surfaces internes de la structure de base 30, les surfaces internes du capot 32, la première paroi P1 de séparation, la deuxième paroi P2 de séparation, la première cloison C1 et la deuxième cloison C2 délimitent entre elles le canal de circulation 26.

En particulier, les surfaces internes de la structure de base 30 et du capot 32, les première, deuxième et troisièmes parois P1, P2, P3 de séparation et les première et deuxième cloisons C1, C2 délimitent les voies de circulation du canal de circulation 26.

Le canal de circulation 26 est décrit en référence aux figures 2 à 4.

En référence à la figure 2, le canal de circulation 26 comprend une entrée 42, une sortie 44 et au moins une portion de canal 51, 52, 53 s'étendant entre l'entrée 42 et la sortie 44. En outre, comme visible sur la figure 2, le canal de circulation 26 présente, par exemple, la forme d'un serpentin. Ainsi, le fluide 28 est configuré pour circuler dans le canal de circulation 26 entre l'entrée 42 et la sortie 44 en passant par l'au moins une portion de canal 51, 52, 53. Par exemple, le canal de circulation 26 comprend une première et une deuxième parties de raccordement fluidique 61, 62 qui seront détaillées dans la suite.

Le fluide 28 est un fluide caloporteur.

Par exemple, le fluide 28 est un liquide.

Par exemple, le fluide 28 est un mélange d'eau et de glycol.

L'entrée 42 permet d'admettre le fluide 28 dans l'au moins une portion de canal 51, 52, 53.

L'entrée 42 est par exemple définie par un orifice traversant ménagé dans l'une des parois transversales 35, 36 de la structure de base 30. L'entrée 42 est apte à être connectée à une source de fluide 28.

La sortie 44 permet d'extraire le fluide 28 du canal de circulation 26.

La sortie 44 est par exemple définie par un orifice traversant ménagé dans l'une des parois transversales 35, 36 de la structure de base 30.

Par exemple, l'entrée 42 et la sortie 44 sont ménagées dans une même paroi transversale 35, 36 de la structure de base 30, à savoir dans la première paroi transversale 35 dans l'exemple illustré sur la figure 2.

Dans l'exemple spécifique décrit dans la présente description, le canal de circulation 26 présente plusieurs portions de canal 51, 52, 53 reliées fluidiquement les unes aux autres par les parties de raccordement fluidique 61, 62. Autrement dit, le fluide 28 peut circuler d'une portion de canal à une autre portion de canal via les parties de raccordement fluidique 61, 62.

Par exemple, le nombre de portions de canal 51, 52, 53 est égal à trois.

En variante, le nombre de portions de canal 51, 52, 53 est différent de trois. Ainsi, par exemple, le nombre de portions de canal 51, 52, 53 peut être égal à un, deux, ou encore être strictement supérieur à trois.

Dans la présente description, les trois portions de canal 51, 52, 53 sont dénommées dans ce qui suit « première portion de canal 51 », « deuxième portion de canal 52 » et « troisième portion de canal 53 ».

Les première, deuxième et troisième portions de canal 51, 52, 53 sont dans cet exemple structurellement analogues les unes aux autres.

Chaque portion de canal 51, 52, 53 comprend au moins une première voie V1 de circulation destinée à conduire le fluide 28 selon une direction principale de circulation DP dans un premier sens S1 de circulation et au moins une deuxième voie V2 de circulation distincte de la première voie V1, destinée à conduire le fluide 28 selon la direction principale de circulation DP dans un deuxième sens S2 de circulation opposé au premier sens S1 de circulation. En outre, pour chaque portion de canal 51, 52, 53, la première voie V1 et la deuxième voie V2 communiquent entre elles par une zone de communication fluidique, notée « ZF ».

Pour chaque portion de canal 51, 52, 53, les références numériques de la première voie V1, de la deuxième voie V2 et de la zone de communication fluidique ZF de cette portion de canal 51, 52, 53 s'écrivent sous la forme Xⱼ, j étant un indice j associé à cette portion de canal 51, 52, 53, lorsqu'il est fait référence à une première voie, une deuxième voie et une zone de communication fluidique spécifique. Ainsi, pour la première portion de canal 51, l'indice « j » est égal à « 1 », pour la deuxième portion de canal 52, l'indice « j » est égal à « 2 » et pour la troisième portion de canal 53, l'indice « j » est égal à 3.

Dans l'exemple décrit, chacune des premières voies V1 de circulation s'étend selon la direction principale de circulation DP.

Dans l'exemple décrit, chacune des deuxièmes voies de circulation V2 s'étend selon la direction principale de circulation DP.

Pour chaque portion de canal 51, 52, 53, la première voie V1 et la deuxième voie V2 de cette portion de canal 51, 52, 53 sont séparées l'une de l'autre par l'une des parois P1, P2, P3 de séparation, dite « paroi de séparation associée ». Dans l'exemple illustré sur la figure 2, la première et la deuxième voies V1, V2 sont en totalité séparées l'une de l'autre par la paroi de séparation P1, P2, P3 associée.

En particulier, ladite direction d'élongation selon laquelle s'étendent les parois P1, P2, P3 de séparation est sensiblement parallèle à la direction principale de circulation DP.

Pour chaque portion de canal 51, 52, 53, la zone de communication fluidique ZF de cette portion de canal 51, 52, 53 est agencée en aval de la première voie V1 de cette portion de canal 51, 52, 53 par rapport au premier sens de circulation S1 et en amont de la deuxième voie V2 de cette portion de canal 51, 52, 53 par rapport au deuxième sens de circulation S2.

Ainsi, comme visible sur la figure 2, la première voie V1₁ et la deuxième voie V2₁ de la première portion de canal 51 sont séparées l'une de l'autre par la première paroi P1 de séparation. En outre, la première voie V1₁ et la deuxième voie V2₁ de la première portion de canal 51 communiquent entre elle par une première zone de communication fluidique ZF₁.

La première voie V1₂ et la deuxième voie V2₂ de la deuxième portion de canal 52 sont séparées l'une de l'autre par la deuxième paroi P2 de séparation. En outre, la première voie V1₂ et la deuxième voie V2₂ de la deuxième portion de canal 52 communiquent entre elle par une deuxième zone de communication fluidique ZF₂.

La première voie V1₃ et la deuxième voie V2₃ de la troisième portion de canal 53 sont séparées l'une de l'autre par la troisième paroi P3 de séparation. En outre, la première voie V1₃ et la deuxième voie V2₃ de la troisième portion de canal 53 communiquent entre elle par une troisième zone de communication fluidique ZF₃.

En outre, comme visible sur la figure 2, les portions de canal 51, 52, 53 sont juxtaposées les unes aux autres selon une direction sensiblement perpendiculaire à la direction principale de circulation DP du fluide 28.

En particulier, la première portion de canal 51, la deuxième portion de canal 52 et la troisième portion de canal 53 sont agencées dans cet ordre par rapport à la circulation du fluide 28 depuis l'entrée 42 vers la sortie 44. En d'autres termes, la première portion de canal 51 correspond à une portion de canal amont par rapport à la circulation du fluide 28 depuis l'entrée 42 vers la sortie 44 et la troisième portion de canal 53 correspond à une portion de canal aval par rapport par rapport à la circulation du fluide 28 depuis l'entrée 42 vers la sortie 44.

Ainsi, dans cet exemple, l'entrée 42 débouche dans la première portion de canal 51 et, en particulier, dans la première voie V1₁ de la première portion de canal 51 et la sortie 44 débouche dans la troisième portion de canal 53 et, en particulier, dans deuxième voie V2₃ de la troisième portion de canal 53.

En outre, dans l'exemple représenté sur la figure 2, les portions de canal 51, 52, 53 sont séparées deux à deux par les cloisons C1, C2. En outre, les portions de canal 51, 52, 53 sont raccordées entre elles deux à deux par les première et deuxième parties de raccordement fluidique 61, 62.

En particulier, dans cet exemple la première portion de canal 51 est séparées de la deuxième portion de canal 52 par la première cloison C1.

La première portion de canal 51 est raccordée fluidiquement à la deuxième portion de canal 52 par la première partie de raccordement fluidique 61.

La première partie de raccordement fluidique 61 est agencée en aval de la deuxième voie V2₁ de la première portion de canal 51 et en amont de la première voie de circulation V1₂ de la deuxième portion de canal 52.

La deuxième portion de canal 52 est séparée de la troisième portion de canal 53 par la deuxième cloison C2.

La deuxième portion de canal 52 est raccordée fluidiquement à la troisième portion de canal 53 par la deuxième partie de raccordement fluidique 62.

La deuxième partie de raccordement fluidique 62 est agencée en aval de la deuxième voie de circulation V2₂ de la deuxième portion de canal 52 et en amont de la première voie de circulation V1₃ de la troisième portion de canal 53.

Comme visible sur la figure 2, le dispositif 22 d'échange thermique comprend, en outre, pour chaque portion de canal 51, 52, 53, au moins un premier module M1 d'échange thermique et au moins un deuxième module M2 d'échange thermique. Optionnellement et comme illustré sur la figure 2, le dispositif 22 d'échange thermique comprend, en outre, pour chaque portion de canal 51, 52, 53, un troisième module M3 d'échange thermique et un quatrième module M4 d'échange thermique.

Comme visible sur la figure 2, pour chaque portion de canal 51, 52, 53, le premier module M1 d'échange thermique de cette portion de canal 51, 52, 53 s'étend exclusivement dans la première voie V1 de cette portion de canal 51, 52, 53.

Pour chaque portion de canal 51, 52, 53, le deuxième module M2 d'échange thermique de cette portion de canal 51, 52, 53 s'étend exclusivement dans la deuxième voie V2 de cette portion de canal 51, 52, 53.

Pour chaque portion de canal 51, 52, 53, le premier module M1 d'échange thermique et le deuxième module M2 d'échange thermique de cette portion de canal 51, 52, 53 sont agencés en regard l'un de l'autre selon une direction sensiblement perpendiculaire à la direction principale de circulation DP et sont séparés l'un de l'autre par la paroi P1, P2, P3 de séparation associée à cette portion de canal 51, 52, 53.

Pour chaque portion de canal 51, 52, 53, le troisième module M3 d'échange thermique de cette portion de canal 51, 52, 53 s'étend exclusivement dans la première voie V1 de cette portion de canal 51, 52, 53.

Pour chaque portion de canal 51, 52, 53, le quatrième module M4 d'échange thermique de cette portion de canal 51, 52, 53 s'étend exclusivement dans la deuxième voie V2 de cette portion de canal 51, 52, 53.

Pour chaque portion de canal 51, 52, 53, le troisième module M3 d'échange thermique et le quatrième module M4 d'échange thermique de cette portion de canal 51, 52, 53 sont agencés en regard l'un de l'autre selon une direction sensiblement perpendiculaire à la direction principale de circulation DP et sont séparés l'un de l'autre par la paroi P1, P2, P3 de séparation associée à cette portion de canal 51, 52, 53.

En outre, comme cela est visible sur les figures 2 et 3, les deux modules M1, M3 et M2, M4 d'une même voie V1, V2 sont espacés l'un de l'autre le long de la direction principale de circulation DP.

Plus précisément, comme visible sur les figures 1 et 2, le premier et le troisième modules M1, M3 agencés dans la première voie V1₁ de la première portion de canal 51 sont espacés l'un de l'autre le long de la direction principale de circulation DP. En outre, comme visible sur la figure 2, le premier et le troisième modules M1, M3 agencés dans la première voie V1₂, V1₃ de chaque autre portion de canal 52, 53 sont espacés des uns des autres le long de la direction principale de circulation DP. En outre, comme visible sur la figure 2, le deuxième et le quatrième modules M2, M4 d'échange thermique agencés dans la première voie V1₁, V1₂, V1₃ de chaque portion de canal 51, 52, 53 sont espacés des uns des autres le long de la direction principale de circulation DP.

Chacun des modules d'échange thermique M1, M2, M3, M4 est fixé à la face interne du fond 38 de la structure de base 30, notamment par brasure, par exemple par brasure sous vide.

Comme visible sur les figures 2 et 3, les modules d'échange thermique M1, M2, M3, M4 sont en contact avec la surface interne du capot 32.

En variante, chacun des modules d'échange thermique M1, M2, M3, M4 est fixé à la face interne du capot 32, notamment par brasure, par exemple par brasure sous vide et les modules d'échange thermique M1, M2, M3, M4 sont en contact avec le fond 38 de la structure de base 30.

Les modules M1, M2, M3, M4 sont décrits plus en détail dans ce qui suit.

Pour chaque portion de canal 51, 52, 53 chacun des premier, deuxième, troisième et quatrième modules M1, M2, M3, M4 d'échange thermique agencés dans cette portion de canal 51, 52, 53 présente, par exemple, une forme sensiblement parallélépipédique. Ainsi, par exemple, chaque module M1, M2, M3, M4 d'échange thermique présente une face d'entrée du fluide 28, une face de sortie du fluide 28, une face supérieure, une face inférieure et deux faces latérales.

La face d'entrée et la face de sortie de chaque module M1, M2, M3, M4 d'échange thermique s'étend sensiblement perpendiculairement à la direction principale de circulation DP.

La face inférieure de chaque module M1, M2, M3, M4 d'échange thermique est dans cet exemple configurée pour être en contact avec la surface interne du fond 38 de la structure de base 30. En particulier, la face inférieure de chaque module M1, M2, M3, M4 d'échange thermique est brasée à la face interne du fond 38 de la structure de base 30.

La face supérieure de chaque module M1, M2, M3, M4 d'échange thermique est dans cet exemple configurée pour être en contact avec la surface interne du capot 32.

Les deux faces latérales de chaque module M1, M2, M3, M4 d'échange thermique s'étendent sensiblement perpendiculairement aux faces d'entrée, de sortie, supérieure et inférieure.

Chaque module M1, M2, M3, M4 d'échange thermique s'étend selon une direction d'extension principale définie par la direction séparant la face d'entrée et la face de sortie de ce module M1, M2, M3, M4 d'échange thermique.

La direction d'extension principale de chaque module M1, M2, M3, M4 d'échange thermique est sensiblement parallèle à la direction principale de circulation DP lorsque ce module M1, M2, M3, M4 d'échange thermique est agencé dans le canal de circulation 26.

Les modules d'échange thermique M1, M2, M3, M4 peuvent être vues comme des éléments de garnissage garnissant le canal de circulation 26.

Pour chaque portion de canal 51, 52, 53, chacun des premier, deuxième, troisième et quatrième modules M1, M2, M3, M4 d'échange thermique agencés dans cette portion de canal 51, 52, 53 est obtenu par fabrication additive.

La fabrication additive est également appelée impression 3D.

Par fabrication additive, il est notamment entendu la fabrication d'un élément en ajoutant de la matière par couches successives.

Par « obtenu par fabrication additive », il est entendu un élément qui présente une structure matérielle spécifique obtenue par fabrication additive et/ou une géométrie qui peut être obtenue de préférence uniquement par fabrication additive.

L'homme du métier comprend que la fabrication additive implique des caractéristiques spécifiques sur la structure matérielle et la géométrie des modules M1, M2, M3, M4 d'échange thermique. En particulier, l'homme du métier distingue une structure matérielle et une géométrie obtenue par fabrication additive par rapport à des structures obtenues par d'autres techniques de fabrication, telles que le soudage, l'usinage, le moulage ou le forgeage.

Par exemple, chaque module M1, M2, M3, M4 d'échange thermique est obtenue exclusivement par fabrication additive.

Par exemple, chaque module M1, M2, M3, M4 d'échange thermique est en aluminium.

Chaque module M1, M2, M3, M4 d'échange thermique présente des régions de passage du fluide 28.

Plus précisément chaque module M1, M2, M3, M4 d'échange thermique présente une structure tridimensionnelle.

La structure de chaque module M1, M2, M3, M4 est définie par un corps, dans le présent exemple en aluminium, dans lequel sont ménagés les régions de passage de fluide.

Le corps pourvu des régions de passage délimite une surface d'échange thermique de ce module M1, M2, M3, M4 d'échange thermique.

La fabrication additive permet notamment de réaliser des formes ou des assemblages qui ne peuvent être obtenues par les autres techniques de fabrication précitées. Ainsi, les régions de passage de fluide des modules M1, M2, M3, M4 sont par exemple facilement réalisables par fabrication additive, alors qu'elles ne sont pas facilement obtenues par moulage en raison de contraintes pour le démoulage. Par soudage, usinage ou forgeage, la présence de telles régions de passage de fluide nécessite plusieurs opérations de réalisation, telles que des opérations complexes de découpage et/ou d'assemblage, alors qu'elles peuvent être obtenues en une seule opération de fabrication additive.

Pour chaque module M1, M2, M3, M4 d'échange thermique, les régions de passage de fluide 28 de ce module M1, M2, M3, M4 d'échange thermique sont notamment traversantes selon la direction d'extension principale de ce module M1, M2, M3, M4 d'échange thermique de sorte que le fluide 28 peut entrer dans le module M1, M2, M3, M4 d'échange thermique par la face d'entrée et sortir du module M1, M2, M3, M4 d'échange thermique par la face de sortie (i.e. traverser le module d'échange thermique).

En outre, les régions de passage 64 de fluide 28 sont traversantes selon une direction perpendiculaire à la direction principale de circulation et à la face interne du capot 32 de sorte que le fluide 28 peut sortir des modules M1, M2, M3, M4 d'échange thermique par les faces supérieures et inférieure du module M1, M2, M3, M4 d'échange thermique de sorte à venir en contact avec les surfaces internes du fond 38 de la structure de base 30 et du capot 32.

Dans l'exemple spécifique montré sur la figure 2, pour chaque portion de canal 51, 52, 53 les premier, deuxième, troisième et quatrième modules M1, M2, M3, M4 sont analogues.

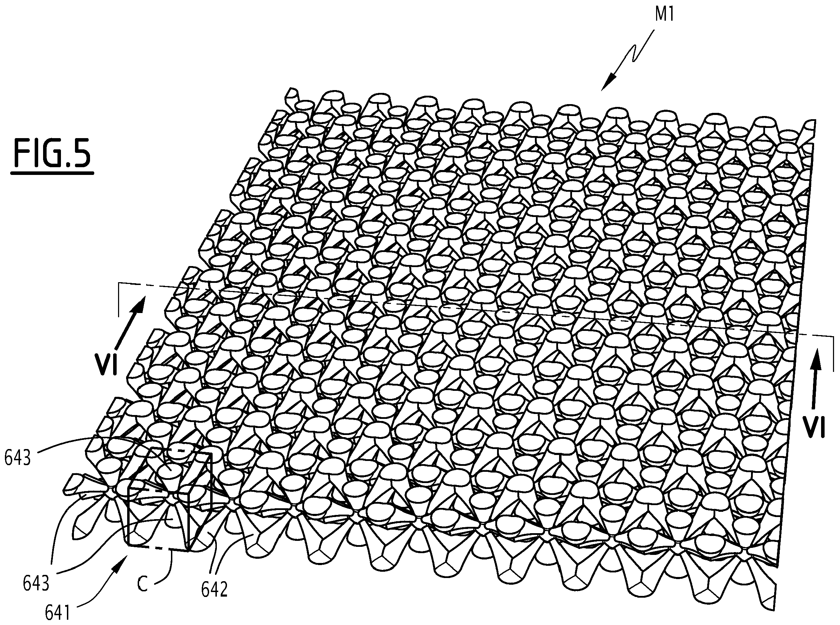

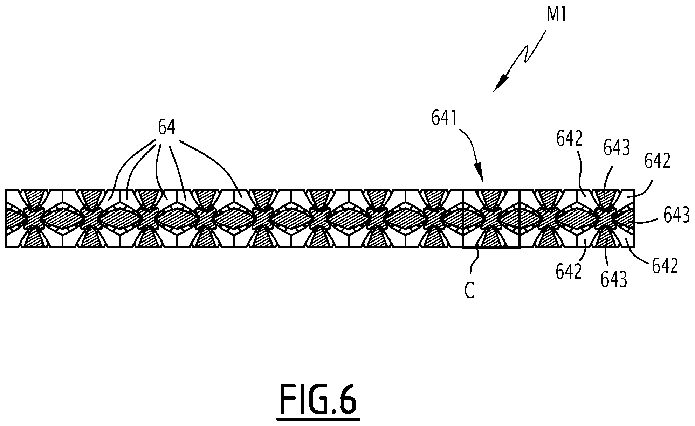

Les figures 5 et 6 montrent en particulier une vue de détail du premier module M1 agencé dans la première portion de canal 51.

La figure 6 montre en particulier les régions de passage 64 de fluide 28 du module M1.

En variante, pour chaque portion de canal 51, 52, 53 au moins deux modules M1, M2, M3, M4 d'échange thermique agencés dans cette portion de canal 51, 52, 53 sont différents, à savoir présentent régions de passage de fluide différentes d'un module à l'autre, c'est-à-dire présentant dans un plan de coupe perpendiculaire à la direction principale de circulation des sections différentes.

Par exemple, pour chaque portion de canal 51, 52, 53 au moins le premier et deuxième modules M1, M2 présentent des régions de passage de fluide différentes d'un module à l'autre. En outre, par exemple, au moins le troisième et le quatrième modules M3, M4 présentent des régions de passage de fluide différentes d'un module à l'autre.

Par exemple, pour chaque portion de canal 51, 52, 53 les premier, deuxième, troisième et quatrième modules M1, M2, M3, M4 sont différents les uns des autres, c'est-à-dire qu'ils présentent des régions de passage de fluide différentes d'un module à l'autre.

Des variantes de premier module M1 d'échange thermique sont représentés sur les figures 6 à 12.

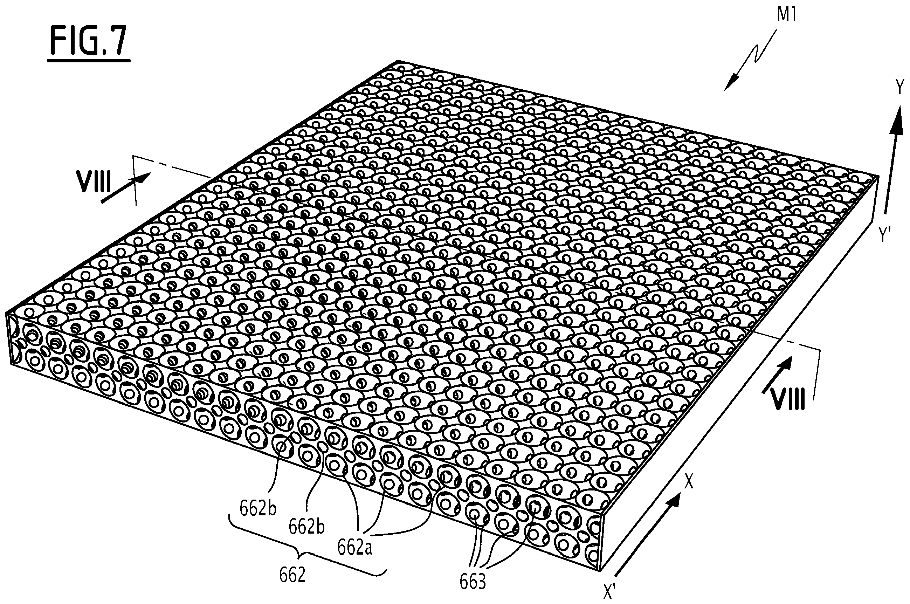

Sur les figures 7 à 12, le premier module M1 présente des régions de passage 66, 68, 70 de fluide 28 différentes des régions de passage 64 représentées sur les figures 5 et 6.

Plus précisément, dans le mode de réalisation des figures 5 et 6, les régions de passage 64 de fluide 28 ont une géométrie de type « cubique », en ce sens que les régions de passage 64 sont formées par répétition d'un motif cubique 641. Le motif cubique 641 comprend huit branches principales 642 s'inscrivant dans un cube C à chacun des sommets duquel est positionnée une extrémité de l'une des huit branches principales 642, les huit branches principales 642 étant en continuité de matière les unes avec les autres au niveau d'une deuxième extrémité placée au centre du cube C.

Si deux répétitions du motif cubique 641 ont un sommet commun, une branche principale 642 appartenant à une première de ces répétitions et une branche principale 642 appartenant à une seconde de ces répétitions dont une extrémité de chacune est positionnée au niveau de ce sommet commun sont en continuité de matière l'une avec l'autre au niveau du sommet commun.

Le motif cubique 641 comprend en outre quatre branches complémentaires 643, une première extrémité d'une première branche complémentaire 643 étant positionnée au centre d'une première face du cube C, une première extrémité d'une deuxième branche complémentaire 643 étant positionnée au centre d'une deuxième face du cube C opposée à la première face, une première extrémité d'une troisième branche complémentaire 643 étant positionnée au centre d'une troisième face du cube C, une première extrémité d'une deuxième branche complémentaire 643 étant positionnée au centre d'une quatrième face du cube C opposée à la troisième face, les quatre branches complémentaires 643 étant en continuité de matière l'une avec l'autre et avec les huit branches principales 642 au niveau d'une deuxième extrémité respective au niveau du centre du cube C.

Si deux répétitions du motif cubique 641 ont une face commune, une branche complémentaire 643 appartenant à une première de ces répétitions et une branche complémentaire 643 appartenant à une seconde de ces répétitions sont en continuité de matière l'une avec l'autre au niveau de la face commune.

Le fluide 28 circule dans les motifs 641 dans l'espace vide entre les branches principales 642 et complémentaires 643.

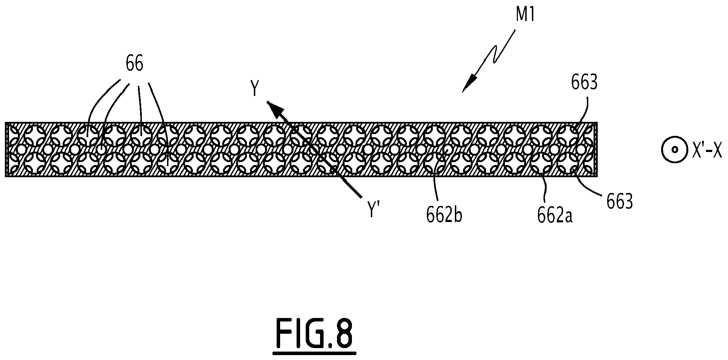

Dans le mode de réalisation des figures 7 et 8, les régions de passage 66 de fluide 28 ont une géométrie de type « éponge », en ce sens que les régions de passage 66 sont formées par une pluralité de premiers canaux 662 cylindriques de révolution s'étendant suivant une première direction X'X, deux premiers canaux 662 premiers voisins étant connectés fluidiquement entre eux par une pluralité de deuxièmes canaux 663 cylindriques de révolution, dont au moins une partie est d'axe parallèle à une deuxième direction Y'Y orthogonale à la première direction X'X.

De préférence, les premiers canaux 662 comprennent des canaux 662a tous identiques ainsi que des canaux 662b tous identiques mais de diamètres différents des canaux 662a.

Les canaux 662a sont de préférence régulièrement espacés.

Les canaux 662b sont de préférence régulièrement espacés en quinconce avec les canaux 662a.

De préférence, les deuxièmes canaux 663 tous identiques et de même diamètre qu'au moins une partie des premiers canaux 662, par exemple - le cas échéant - les canaux 662b.

Le fluide 28 circule à l'intérieur des premiers et deuxièmes canaux 662 et 663.

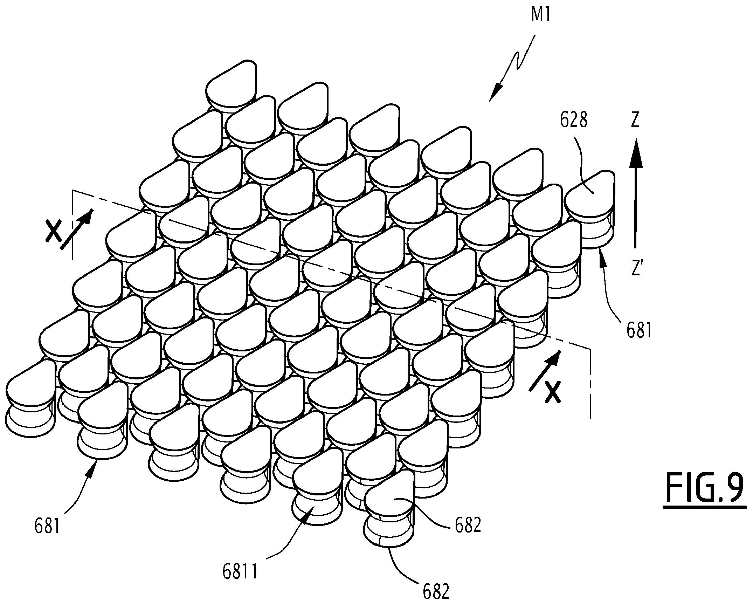

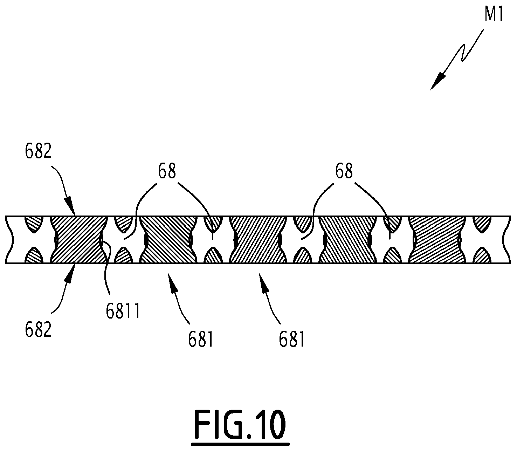

Dans le mode de réalisation des figures 9 et 10, les régions de passage 68 de fluide 28 ont une géométrie de type « gouttes », en ce sens que les régions de passage 66 sont délimitées par une pluralité de piliers 681 s'étendant suivant une troisième direction Z'Z entre deux bases 682 en forme de gouttes (ou équivalemment de larmes), les deux bases 682 étant parallèles l'une à l'autre.

Les piliers 681 présentent de préférence un col 6811.

Les piliers 681 sont disposés en quinconce suivant un plan orthogonal à la troisième direction Z'Z.

Le fluide 28 circule dans l'espace vide entre les piliers 681.

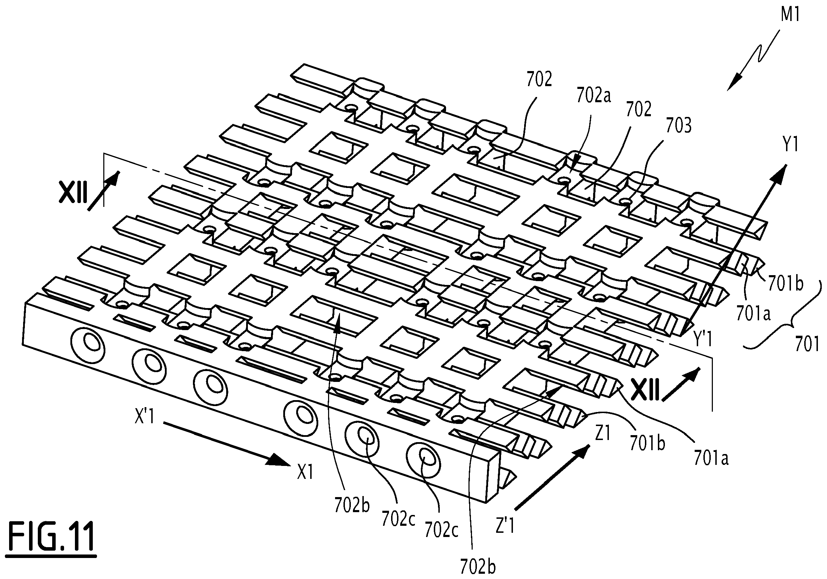

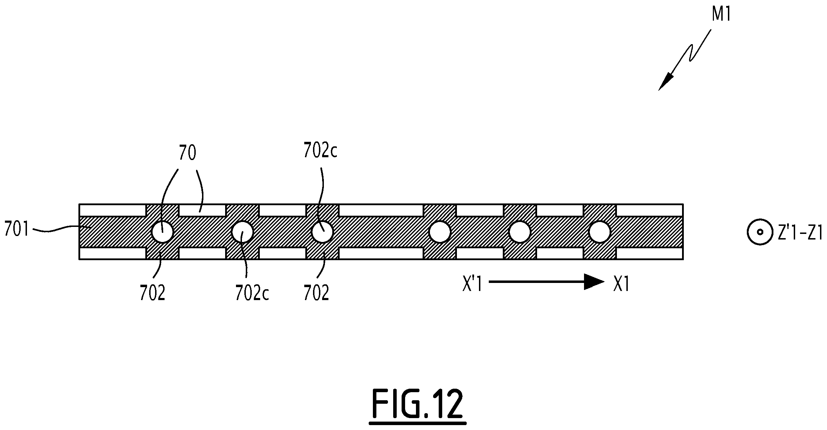

Dans le mode de réalisation des figures 11 et 12, les régions de passage 70 de fluide 28 sont délimitées par une pluralité de cylindres 701 de base polygonale, de préférence rectangulaire 701a, et/ou triangulaire 701b, d'axes de direction X'1X1 et décalés les uns par rapport aux autres suivant une direction Y'1Y1 orthogonale à la direction X'1X1.

Les cylindres 701 sont reliés entre eux par une pluralité de traverses parallélépipédiques 702 s'étendant suivant une direction Z'1Z1 orthogonale à la direction X'1X1.

Une pluralité d'encoches parallélépipédiques 702a, 702b est ménagée sur deux faces opposées des traverses 702, chaque encoche 702a d'une première des deux faces étant en regard d'une encoche 702b de la face opposée, un trou traversant cylindrique 703 étant en outre formé entre chaque paire d'encoches 702a et 702b en regard l'une de l'autre.

Un usinage 702c cylindrique est par ailleurs formé dans chaque traverse 702 sur toute sa longueur suivant la direction Z'1Z1.

Le fluide 28 circule dans l'espace vide entre les traverses 702 et les cylindres 701, notamment dans les encoches 702a, 702b, ainsi qu'au travers des trous traversants 703 et des usinages 702c.

En variante ou en complément, pour chaque portion de canal 51, 52, 53, le premier module M1, le deuxième module M2, le troisième module M3, le quatrième module M4 peut correspondre à l'un quelconque des modules montrés sur les figures 5, 7, 9, 11.

En outre, d'autres géométries que celles représentées sur les figures 6 à 12 peuvent être envisagées.

En particulier, les régions de passage de fluide des modules M1, M2, M3, M4 d'échange thermique sont adaptées en fonction de paramètres prédéfinis.

Ces paramètres prédéfinis comprennent, par exemple, la surface d'échange thermique définie par le module M1, M2, M3, M4 d'échange thermique, les pertes de charges lorsque le fluide 28 traverse le module M1, M2, M3, M4 d'échange thermique, la répartition du fluide 28 au sein du module M1, M2, M3, M4 d'échange thermique, notamment le guidage du fluide 28 vers les surfaces internes supérieures et inférieures du fond 38 de la structure de base 30 et du capot 32 par lesdites régions de passage de fluide 28.

Par exemple, pour chaque portion de canal 51, 52, 53, le dispositif 22 comprend une première zone de contact ZC externe et une deuxième zone de contact ZC externe.

Pour chaque portion de canal 51, 52, 53, la première zone de contact ZC est une portion de la surface de contact externe s'étendant avantageusement à la fois au droit des premier et deuxième modules M1, M2 d'échange thermique agencés dans cette portion de canal 51, 52, 53.

Pour chaque portion de canal 51, 52, 53, la deuxième zone de contact ZC s'étend avantageusement à la fois au droit des troisième et quatrième modules M3, M4 d'échange thermique agencés dans cette portion de canal 51, 52, 53.

En variante, pour chaque portion de canal 51, 52, 53, le dispositif 22 d'échange thermique comprend une première, une deuxième, une troisième et une quatrième zone de contact ZC. Dans ce cas, pour chaque portion de canal 51, 52, 53, chacune des zones de contact ZC est agencée au droit d'un module M1, M2, M3, M4 d'échange thermique respectif parmi le premier, deuxième, troisième, quatrième modules M1, M2, M3, M4 agencés dans cette portion de canal 51, 52, 53.

Initialement, le fluide 28 entre par l'entrée 42 du dispositif 22 d'échange thermique.

Puis, le fluide 28 traverse les premier et troisième modules M1, M3 d'échange thermique agencés dans la première voie V1₁ de la première portion de canal 51 puis traverse les quatrième et deuxième modules M4, M2 d'échange thermique agencés dans la deuxième voie V2₁ de la première portion de canal 51.

Ensuite, le fluide 28 traverse les premier et troisième modules M1, M3 d'échange thermique agencés dans la première voie V1₂ de la deuxième portion de canal 52 puis traverse les quatrième et deuxième modules M4, M2 d'échange thermique agencés dans la deuxième voie V2₂ de la deuxième portion de canal 52.

Enfin, le fluide 28 traverse les premier et troisième modules M1, M3 d'échange thermique agencés dans la première voie V1₃ de la troisième portion de canal 53 puis traverse les quatrième et deuxième modules M4, M2 d'échange thermique agencés dans la deuxième voie V2₃ de la troisième portion de canal 53 et sort par la sortie 44.

En particulier, au cours de sa circulation dans le dispositif 22 d'échange thermique, le fluide 28 passe par les régions de passage 64 de fluide 28 de chacun des modules M1, M2, M3, M4 d'échange thermique. Le passage du fluide 28 dans les régions de passage de fluide 28 permet de répartir le fluide dans le module M1, M2, M3, M4 d'échange thermique de sorte que le fluide passe sur les surfaces internes de la structure de base 30 et du capot 32 agencées au droit des modules M1, M2, M3, M4.

Une telle répartition du fluide 28 au sein des modules M1, M2, M3, M4 d'échange thermique permet un bon échange thermique avec les unités 24 de sorte à les refroidir.

Au cours de sa circulation dans le canal de circulation 26 et à travers les modules M1, M2, M3, M4 d'échange thermique, le fluide 28 échange de la chaleur par conduction et convection avec les unités 24, ce qui permet de les refroidir.

Le procédé de fabrication de l'ensemble 20 est décrit dans la suite.

Le procédé de fabrication comprend d'abord la fabrication du dispositif 22 d'échange thermique puis l'agencement des unités 24 sur les zones de contact ZC de la surface de contact.

Le procédé de fabrication du dispositif 22 d'échange thermique comprend les étapes suivantes :
- réalisation du canal de circulation 26,
- réalisation par fabrication additive, pour chaque portion de canal 51, 52, 53, des premier, deuxième, troisième et quatrième modules M1, M2, M3, M4 présentant les régions de passage 64 de fluide 28,
- pour chaque portion de canal 51, 52, 53, agencement du premier module M1 d'échange thermique de cette portion de canal 51, 52, 53 dans la première voie V1 de cette portion de canal 51, 52, 53, de sorte qu'il s'étende exclusivement dans ladite première voie V1,
- pour chaque portion de canal 51, 52, 53, agencement du deuxième module M2 d'échange thermique de cette portion de canal 51, 52, 53, dans la deuxième voie V2 de cette portion de canal 51, 52, 53 de sorte qu'il s'étende exclusivement dans la deuxième voie V2 de circulation, qu'il soit agencé en regard du premier module M1 d'échange thermique de cette portion de canal 51, 52, 53 selon une direction sensiblement perpendiculaire à la direction principale de circulation DP et qu'il soit séparé du premier module M1 d'échange thermique de cette portion de canal 51, 52, 53 par la paroi P1, P2, P3 de séparation associée à cette portion de canal 51, 52, 53,
- pour chaque portion de canal 51, 52, 53, agencement du troisième module M3 d'échange thermique dans la première voie V1 de cette portion de canal 51, 52, 53, de sorte qu'il s'étende exclusivement dans ladite première voie V1 et qu'il soit espacé du premier module M1 d'échange thermique de cette portion de canal 51, 52, 53 le long de la direction principale d'extension DP,
- pour chaque portion de canal 51, 52, 53, agencement du quatrième module M4 d'échange thermique dans la deuxième voie V2 de cette portion de canal 51, 52, 53, de sorte qu'il s'étende exclusivement dans la deuxième voie V2, qu'il soit agencé en regard du troisième module M3 d'échange thermique de cette portion de canal 51, 52, 53 selon une direction sensiblement perpendiculaire à la direction principale de circulation DP et qu'il soit séparés du troisième module M3 d'échange thermique de cette portion de canal 51, 52, 53 par la paroi P1, P2, P3 de séparation associée à cette portion de canal 51, 52, 53.

En outre, pour chaque portion de canal 51, 52, 53, le quatrième module M4 d'échange thermique est espacé du deuxième module M2 d'échange thermique de cette portion de canal 51, 52, 53 le long de la direction principale de circulation DP.

L'étape de réalisation du canal de circulation 26 comprend, par exemple, une sous-étape de fourniture de la structure de base 30, une sous-étape de fourniture du capot 32 et une sous-étape de solidarisation des parois P1, P2, P3 de séparation et des cloisons C1, C2 à la surface interne de la structure de base 30 ou du capot 32, par exemple par brasure, de sorte à former au moins en partie les portions de canal 51, 52, 53 du canal de circulation 26.

L'étape de réalisation du canal de circulation 26 comprend, en outre, une sous-étape de solidarisation du capot 32 à la structure de base 30.

La solidarisation du capot 32 à la structure de base 30 est par exemple réalisée par brasure. Ainsi, les bords du capot 32 sont brasés aux bords de la structure de base 30.

La solidarisation du capot 32 à la structure de base 30 permet de rendre le dispositif 22 d'échange thermique étanche.

Par exemple, le procédé comprend une étape de fixation des modules M1, M2, M3, M4 d'échange thermique à la surface interne de la structure de base 30 ou du capot 32, notamment par brasure et, par exemple, par brasure sous vide.

Dans le cas d'espèce, lors de l'étape de fixation des modules M1, M2, M3, M4, les modules M1, M2, M3, M4 d'échange thermique sont brasés sous vide à la surface interne de la structure de base 30.

Les étapes relatives à l'agencement des modules M1, M2, M3, M4 d'échange thermique dans le canal de circulation 26 et de fixation des modules M1, M2, M3, M4 d'échange thermique sont réalisées avant la sous-étape de solidarisation du capot 32 à la structure de base 30.

Une fois la structure de base 30 et le capot 32 solidarisés l'un à l'autre, le procédé comprend, en outre, l'agencement de chaque unité 24 sur l'une des zones de contact ZC de la surface de contact.

Selon une variante du procédé de fabrication du dispositif 22 d'échange thermique, l'étape de réalisation du canal de circulation 26 ne comprend pas la sous-étape de solidarisation. En effet, lors de la sous-étape de fourniture de la structure de base 30, les parois P1, P2, P3 de séparation et les cloisons C1, C2 sont déjà solidarisées à la surface interne de la structure de base 30 ou du capot 32. Dans ce cas, par exemple, les parois P1, P2, P3 de séparation et les cloisons C1, C2 sont venues de matière avec la structure de base 30 ou le capot 32. Par exemple, les parois P1, P2, P3 de séparation et les cloisons C1, C2 sont usinées dans la structure de base 30 ou dans le capot 32.

Selon une autre variante du procédé du dispositif 22 d'échange thermique, les parois de séparation P1, P2, P3 sont réalisées par fabrication additive concomitamment à l'étape de fabrication additive des modules d'échange thermique M1, M2, M3, M4. Dans ce cas, par exemple, pour chaque portion de canal 51, 52, 53, chaque paroi de séparation P1, P2, P3 de cette portion de canal 51, 52, 53 est venue de matière avec les modules d'échange thermique M1, M2, M3, M4 de cette portion de canal 51, 52, 53. Selon un autre exemple, pour chaque portion de canal 51, 52, 53, la paroi de séparation P1, P2, P3 de cette portion de canal 51, 52, 53 est réalisée en plusieurs portions de parois de séparation P1, P2, P3 fixées les unes aux autres. Chaque portion de paroi de séparation P1, P2, P3 est dans cette exemple venue de matière avec les deux modules d'échange thermique (M1 et M2 d'une part et M3 et M4 d'autre part) agencées en regard l'un de l'autre selon la direction sensiblement perpendiculaire à la direction principale de circulation DP.

Selon cette variante du procédé, la sous-étape de solidarisation des parois P1, P2, P3 de séparation à la surface interne de la structure de base 30 est réalisée concomitamment à l'étape de fixation des modules à la surface interne de la structure de base 30 ou du capot 32, notamment par brasure et, par exemple, par brasure sous vide.

Le dispositif 22 d'échange thermique selon l'invention permet d'assurer un échange thermique performant avec les unités 24 destinées à être refroidies ou réchauffées, tout en étant facile à fabriquer.

En particulier, grâce à l'invention, un dispositif 22 d'échange thermique modulaire est obtenu. En effet, il est possible de personnaliser le dispositif 22 d'échange thermique selon l'invention en choisissant des modules M1, M2, M3, M4 d'échange thermique présentant des régions de passages de fluide optimales en fonction des capacités de refroidissement nécessaires pour refroidir les unités 24. En outre, il est possible d'adapter le nombre de portions de canal en fonction du nombre d'unités 24 à refroidir ou à réchauffer.

L'utilisation de la fabrication additive permet en particulier d'adapter la géométrie tridimensionnelle des modules M1, M2, M3, M4 d'échange thermique, et en particulier, d'adapter la forme des régions de passage de fluide 28 et donc des surfaces d'échange thermique de ces modules M1, M2, M3, M4 d'échange thermique, afin de refroidir de manière optimale les unités 24. En d'autres termes, grâce à l'aspect modulaire du dispositif 22 d'échange thermique selon l'invention, il est possible de choisir les modules M1, M2, M3, M4 d'échange thermique optimaux de sorte à obtenir un dispositif 22 d'échange thermique présentant une performance thermique améliorée par rapport au dispositif d'échange thermique de l'état de la technique.

Un paramètre pour évaluer la performance thermique un dispositif 22 d'échange thermique est la résistance thermique.

En choisissant une forme adaptée des régions de passage de fluide 28 des modules M1, M2, M3, M4 d'échange thermique, il est possible d'obtenir un dispositif 22 d'échange thermique présentant une résistance thermique strictement inférieure au dispositif d'échange thermique de l'état de la technique.

L'utilisation de modules d'échange thermique tel que ceux montrés sur les figures 5 à 12 permet d'obtenir un dispositif 22 d'échange thermique ayant une résistance thermique strictement inférieure à la résistance thermique d'un dispositif d'échange thermique comprenant la plaque usinée de l'état de la technique.

En particulier, un dispositif 22 d'échange thermique comprenant des modules M1, M2, M3, M4 d'échange thermique analogues au module d'échange thermique montré sur les figures 5 et 6 présente une résistance thermique 45% plus petite par rapport à la résistance thermique du dispositif d'échange thermique de l'état de la technique pour une pression d'entrée du fluide 28 de 1,41 bars, un débit de fluide 28 en entrée de 20,19 litres par minute et une température 28 du fluide 28 en entrée à 51 degrés Celsius.

En outre, grâce aux modules M1, M2, M3, M4 d'échange thermique obtenus par fabrication additive, il est possible d'adapter la structure de ces modules M1, M2, M3, M4 d'échange thermique de sorte à réduire le gradient de température entre l'entrée 42 et la sortie 44 du dispositif 22 d'échange thermique afin d'équilibrer les échauffements sous l'ensemble des unités 24.

En outre, grâce aux module M1, M2, M3, M4 d'échange thermique obtenus par fabrication additive, il est possible d'adapter la structure de ces modules M1, M2, M3, M4 d'échange thermique en fonction des pertes thermiques qui peuvent être différentes d'une unité 24 à l'autre.

De plus, grâce aux modules M1, M2, M3, M4 d'échange thermique obtenus par fabrication additive, il est possible d'augmenter les surfaces d'échange thermique du dispositif 22 d'échange thermique tout en obtenant un dispositif 22 d'échange thermique particulièrement compact (i.e. pas d'augmentation du volume d'échange thermique par rapport aux dispositifs de l'état de la technique).

Enfin, le dispositif 22 d'échange thermique selon l'invention est facile à fabriquer.

## Revendications

1. Dispositif (22) d'échange thermique définissant un canal de circulation (26) d'un fluide (28) apte à être réchauffé ou refroidi par échange thermique avec une unité (24) destinée à être refroidie ou réchauffée, le canal de circulation (26) comprenant une entrée (42), une sortie (44) et au moins une portion de canal (51, 52, 53) s'étendant entre l'entrée (42) et la sortie (44), la portion de canal (51, 52, 53) comprenant au moins une première voie (V1) de circulation destinée à conduire le fluide (28) selon une direction principale de circulation (DP) dans un premier sens (S1) et au moins une deuxième voie (V2) de circulation distincte de la première voie (V1), destinée à conduire le fluide (28) selon la direction principale de circulation (DP) dans un deuxième sens (S2) opposé au premier sens (S1), la première voie (V1) et la deuxième voie (V2) étant séparées l'une de l'autre par une paroi de séparation (P1, P2, P3),
le dispositif (22) d'échange thermique comprenant, en outre, au moins un premier module (M1) d'échange thermique et un deuxième module (M2) d'échange thermique, le premier module (M1) d'échange thermique s'étendant exclusivement dans la première voie (V1) de circulation et le deuxième module (M2) d'échange thermique s'étendant exclusivement dans la deuxième voie (V2) de circulation, les premier et deuxième modules (M1, M2) d'échange thermique présentant des régions de passage (64, 66, 68, 70) de fluide (28) et étant obtenus par fabrication additive,
le premier module (M1) d'échange thermique et le deuxième module (M2) d'échange thermique étant agencés en regard l'un de l'autre selon une direction sensiblement perpendiculaire à la direction principale de circulation (DP) et étant séparés l'un de l'autre par la paroi de séparation (P1, P2, P3).

2. Dispositif d'échange thermique selon la revendication 1, dans lequel le dispositif (22) d'échange thermique comprend, en outre, un troisième module (M3) d'échange thermique et un quatrième module (M4) d'échange thermique, le troisième module (M3) d'échange thermique s'étendant exclusivement dans la première voie (V1) et étant espacé du premier module (M1) d'échange thermique selon la direction principale de circulation (DP), le quatrième module (M4) d'échange thermique s'étendant exclusivement dans la deuxième voie (V2) et étant espacé du deuxième module (M2) d'échange thermique selon la direction principale de circulation (DP), le troisième module (M3) d'échange thermique et le quatrième module (M4) d'échange présentant des régions de passage de fluide (64, 66, 68, 70) et étant obtenus par fabrication additive, le troisième module (M3) d'échange thermique et le quatrième module (M4) d'échange thermique étant agencés en regard l'un de l'autre selon une direction sensiblement perpendiculaire à la direction principale de circulation (DP) et étant séparés l'un de l'autre par la paroi de séparation (P1, P2, P3).

3. Dispositif d'échange thermique selon la revendication 1 ou 2, comprenant une structure de base (30) et un capot (32) fixé à la structure de base (30), de préférence par brasure, la structure de base (30) et le capot (32) présentant des surfaces internes délimitant entre elles au moins en partie un volume interne (40) du dispositif (22) d'échange thermique, le volume interne (40) définissant le canal de circulation (26).

4. Dispositif d'échange thermique selon la revendication 3, dans lequel les modules (M1, M2, M3, M4) d'échange thermique sont fixés par brasure à la surface interne de la structure de base (30) ou du capot (32).

5. Dispositif d'échange thermique selon l'une quelconque des revendications précédentes, dans lequel le canal de circulation (26) présente la forme d'un serpentin, le canal de circulation (26) comprenant au moins une première portion de canal (51) et une deuxième portion de canal (52) agencées entre l'entrée (42) et la sortie (44), pour chacune des portions de canal parmi la première portion de canal (51) et la deuxième portion de canal (52), la première voie (V1) de circulation et la deuxième voie (V2) de circulation de cette portion de canal (51, 52) étant séparées l'une de l'autre par une paroi de séparation (P1, P2) associée à cette portion de canal (51, 52),
pour chacune des portions de canal parmi la première portion de canal (51) et la deuxième portion de canal (52), le dispositif (22) d'échange thermique comprend au moins un premier module (M1) d'échange thermique et un deuxième module (M2) d'échange thermique, le premier module (M1) d'échange thermique s'étendant exclusivement dans la première voie (V1) de circulation de cette portion de canal (51, 52) et le deuxième module (M2) d'échange thermique s'étendant exclusivement dans la deuxième voie (V2) de circulation de cette portion de canal (51, 52), les premier et deuxième modules (M1, M2) d'échange thermique présentant des régions de passage (64, 66, 68, 70) de fluide et étant obtenus par fabrication additive,
pour chacune des portions de canal parmi la première portion de canal (51) et la deuxième portion de canal (52), le premier module (M1) d'échange thermique et le deuxième module (M2) d'échange thermique de cette portion de canal (51, 52) étant agencés en regard l'un de l'autre selon une direction sensiblement perpendiculaire à la direction principale de circulation (DP) et étant séparés l'un de l'autre par la paroi de séparation (P1, P2) associée à cette portion de canal (51, 52).

6. Dispositif d'échange thermique selon la revendication 5, comprenant une cloison (C1, C2) séparant la première portion de canal (51) et la deuxième portion de canal (52).

7. Dispositif d'échange thermique selon l'une quelconque des revendications précédentes, dans lequel au moins deux modules (M1, M2, M3, M4) d'échange thermique présentent des régions de passage (64, 66, 68, 70) de fluide (28) différentes d'un module d'échange thermique à l'autre.

8. Dispositif d'échange thermique selon l'une quelconque des revendications précédentes, dans lequel au moins un module (M1, M2, M3, M4) d'échange thermique présente des régions de passage (64) formées par répétition d'un motif cubique (641) comprenant huit branches principales (642) s'inscrivant dans un cube (C), à chacun des sommets duquel est positionnée une extrémité de l'une des huit branches principales (642), les huit branches principales (642) étant en continuité de matière les unes avec les autres au niveau d'une deuxième extrémité placée au centre du cube (C),
le motif cubique (641) comprenant en outre quatre branches complémentaires (643), une première extrémité d'une première branche (643) et une première extrémité d'une deuxième branche complémentaire (643) étant positionnées respectivement au centre d'une première face du cube (C) et d'une face du cube opposée à la première face, une première extrémité d'une troisième branche (643) et une première extrémité d'une quatrième branche complémentaire (643) étant positionnées respectivement au centre d'une deuxième face du cube (C) et d'une face du cube opposée à la deuxième face, les quatre branches complémentaires (643) étant en continuité de matière l'une avec l'autre et avec les huit branches principales (642) au niveau d'une deuxième extrémité respective au niveau du centre du cube C,
la répétition du motif cubique (641) étant telle que si deux répétitions du motif cubique (641) ont un sommet commun, une branche principale (642) appartenant à une première de ces répétitions et une branche principale (642) appartenant à une seconde de ces répétitions dont une extrémité de chacune est positionnée au niveau de ce sommet commun sont en continuité de matière l'une avec l'autre au niveau du sommet commun,
les régions de passage (64) étant configurées pour que le fluide circule dans un volume vide entre les branches principales (642) et/ou complémentaires (643).

9. Dispositif d'échange thermique selon l'une quelconque des revendications précédentes, dans lequel au moins un module (M1, M2, M3, M4) d'échange thermique présente des régions de passage (66) comprenant une pluralité de premiers canaux (662) de circulation du fluide cylindriques de révolution s'étendant suivant une première direction (X'X), deux premiers canaux (662) premiers voisins étant connectés fluidiquement entre eux par une pluralité de deuxièmes canaux (663) de circulation du fluide cylindriques de révolution, dont au moins une partie est d'axe parallèle à une deuxième direction (Y'Y) orthogonale à la première direction (X'X).

10. Dispositif d'échange thermique selon l'une quelconque des revendications précédentes, dans lequel au moins un module (M1, M2, M3, M4) d'échange thermique présente des régions de passage (68) délimitées par une pluralité de piliers (681) s'étendant suivant une direction principale (Z'Z) entre deux bases (682) chacune en forme de goutte, les deux bases (682) étant parallèles l'une à l'autre, les piliers (681) étant disposés en quinconce suivant un plan orthogonal à la direction principale (Z'Z), les régions de passage (68) étant configurées pour que le fluide circule dans un volume vide entre les piliers (681).

11. Dispositif d'échange thermique selon l'une quelconque des revendications précédentes, dans lequel au moins un module (M1, M2, M3, M4) d'échange thermique présente des régions de passage (70) délimitées par une pluralité de cylindres (701) de base polygonale d'axes s'étendant suivant une direction de base (X'1X1) et décalés les uns par rapport aux autres suivant une direction d'espacement (Y'1Y1) orthogonale à la direction de base (X'1X1),
les cylindres (701) étant reliés entre eux par une pluralité de traverses parallélépipédiques (702) s'étendant suivant une direction transverse (Z'1Z1) orthogonale à la direction de base (X'1X1),
une pluralité d'encoches parallélépipédiques (702a, 702b) étant ménagées sur deux faces opposées des traverses (702), chaque encoche (702a) d'une première des deux faces étant en regard d'une encoche (702b) de la face opposée,
un trou traversant cylindrique 703 étant formé entre chaque paire d'encoches (702a) et (702b) en regard l'une de l'autre,
un usinage (702c) cylindrique étant formé dans chaque traverse 702 sur toute sa longueur suivant la direction transverse (Z'1Z1),
les régions de passage (70) étant configurées pour que le fluide 28 circule dans un espace vide entre les traverses (702) et/ou les cylindres (701), et/ou au travers des trous traversants (703) et/ou des usinages (702c).

12. Ensemble (20) comprenant au moins un dispositif (22) d'échange thermique selon l'une quelconque des revendications précédentes et au moins une unité (24) apte à être refroidie ou réchauffée par le dispositif (22) d'échange thermique, le dispositif (22) d'échange thermique comprenant une structure de base (30) et un capot (32) fixé à la structure de base (30), de préférence par brasure, la structure de base (30) et le capot (32) présentant des surfaces internes délimitant entre elles un volume interne (40) du dispositif (22) d'échange thermique, le volume interne (40) définissant le canal de circulation (26) du dispositif (22) d'échange thermique, ladite unité (24) étant agencée en contact avec une zone (ZC) d'une surface externe du capot ou de la structure de base, dite « surface de contact (ZC) », la surface de contact (ZC) s'étendant à l'extérieur du volume interne (40).

13. Ensemble selon la revendication 12, dans lequel ladite unité (24) s'étend sur la zone de contact (ZC) à la fois au droit du premier module (M1) d'échange thermique et du deuxième module (M2) d'échange thermique.

14. Procédé de fabrication d'un dispositif (22) d'échange thermique selon l'une quelconque des revendications 1 à 11 comprenant au moins les étapes de :
- réalisation d'un canal de circulation (26) d'un fluide apte à être réchauffé ou refroidi par échange thermique avec une unité (24) apte à être refroidie ou réchauffée, le canal de circulation (26) comprenant une entrée (42), une sortie (44) et au moins une portion de canal (51, 52, 53) s'étendant entre l'entrée (42) et la sortie (44), la portion de canal (51, 52, 53) comprenant au moins une première voie (V1) de circulation destinée à conduire le fluide (28) selon une direction principale de circulation (DP) dans un premier sens (S1) et au moins une deuxième voie (V2) de circulation distincte de la première voie (V1), destinée à conduire le fluide (28) selon la direction principale de circulation (DP) dans un deuxième sens (S2) opposé au premier sens (S1), la première voie (V1) et la deuxième voie (V2) étant séparées l'une de l'autre par une paroi de séparation (P1, P2, P3),
- réalisation d'au moins un premier module (M1) d'échange thermique et un deuxième module (M2) d'échange thermique par fabrication additive, les premier et deuxième modules (M1, M2) d'échange thermique présentant chacun des régions de passage (64, 66, 68, 70) de fluide (28),
- agencement du premier module (M1) d'échange thermique dans la première voie (V1) de circulation de sorte qu'il s'étende exclusivement dans la première voie (V1) de circulation,
- agencement du deuxième module (M2) d'échange thermique dans la deuxième voie (V2) de sorte qu'il s'étende exclusivement dans la deuxième voie (V2) de circulation, qu'il soit agencé en regard du premier module (M1) d'échange thermique selon une direction sensiblement perpendiculaire à la direction principale de circulation (DP) et qu'il soit séparé du premier module (M1) d'échange thermique par la paroi de séparation (P1, P2, P3).
